# EUROPEAN PATENT APPLICATION

(11) **EP 0 617 378 A1**
(43) Date of publication of application: **28.09.1994**
(21) Application number: 94104439.8
(22) Date of filing: 21.03.1994
(51) Int. Cl.: G06G 7/195, H03H 9/145

(54) **Surface acoustic wave element resolving variations in properties in connection with matching circuit, signal receiver using it, and communication system using it**

(30) Priority: 22.03.1993 JP 85133/93; 09.03.1994 JP 38253/94
(71) Applicant: CANON KABUSHIKI KAISHA, Tokyo (JP)
(72) Inventor: Mochizuki, Norihiro, c/o Canon Kabushiki Kaisha, Ohta-ku, Tokyo 146 (JP); Torisawa, Akira, c/o Canon Kabushiki Kaisha, Ohta-ku, Tokyo 146 (JP); Egara, Koichi, c/o Canon Kabushiki Kaisha, Ohta-ku, Tokyo 146 (JP); Eguchi, Tadashi, c/o Canon Kabushiki Kaisha, Ohta-ku, Tokyo 146 (JP); Koyama, Akihiro, c/o Canon Kabushiki Kaisha, Ohta-ku, Tokyo 146 (JP); Hachisu, Takahiro, c/o Canon Kabushiki Kaisha, Ohta-ku, Tokyo 146 (JP)
(74) Representative: Pellmann, Hans-Bernd, Dipl.-Ing.

(57) **Abstract**

A surface acoustic wave apparatus includes a surface acoustic wave (SAW) element and a matching circuit (16). The SAW element includes a piezoelectric substrate (11), two generation electrodes (12,13) provided on the piezoelectric substrate, for generating a first surface acoustic wave and a second surface acoustic wave, respectively, and an output electrode (14) provided on the piezoelectric substrate, for propagating the first and second surface acoustic waves in mutually opposite directions to extract a convolution signal of the first and second surface acoustic waves. The matching circuit effects impedance matching between the element and an external circuit. In the apparatus at least a part of the matching circuit is formed on the piezoelectric substrate.

## Description

### BACKGROUND OF THE INVENTION

### Field of the Invention

The present invention relates to a surface acoustic wave (SAW) element such as a SAW convolver, a signal receiver using it, and a communication system using it.

### Related Background Art

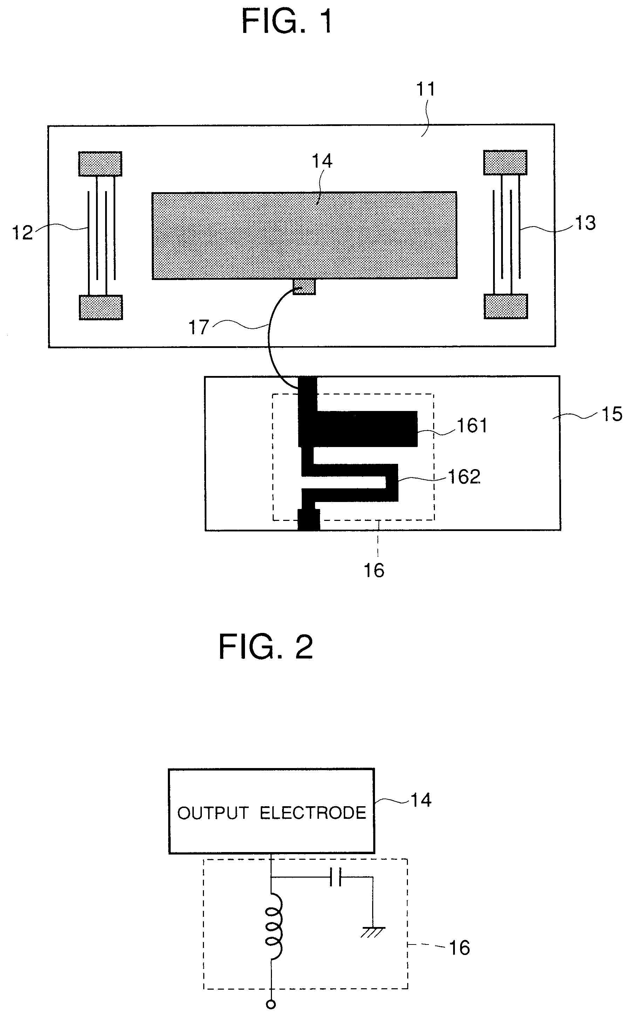

Fig. 1 is a schematic plane view to show the structure of a conventional SAW apparatus. In Fig. 1, reference numeral 11 designates a piezoelectric substrate, and 12, 13 two interdigital electrodes for SAW generation formed at a proper distance to each other on the surface of substrate 11 as opposed to each other. Numeral 14 denotes an output electrode formed between the electrodes 12, 13 on the surface of substrate 11. Numeral 15 represents a printed circuit board for example of glass epoxy, 16 a matching circuit formed on the printed circuit board 15, and 17 a wire for electrically connecting the output electrode 14 with the matching circuit 16.

In this SAW apparatus, when an electric signal of angular frequency ω is input into the SAW generation interdigital electrode 12, 13, a surface acoustic wave of the frequency is generated at each electrode. The surface acoustic waves propagate in mutually opposite directions along the output electrode 14, and the parametric mixing phenomenon generates an electric signal of a product of the two signals with angular frequency 2ω in the output electrode 14. This electric signal is integrated over the output electrode 14, which becomes a convolution electric signal of the above two input signals.

The mechanism of generating the convolution signal is described in detail for example in Shibayama, "Applications of Surface Acoustic Wave," TELEVISION, 30, 457 (1976).

An impedance of output electrode 14 is normally different from that of an external circuit. Thus, the output electrode 14 is connected through the wire 17 to the matching circuit 16 formed on the printed circuit board 15 for example of glass epoxy. In Fig. 1, the matching circuit 16 is constructed of a distributed constant line on the printed circuit board 15, which is composed of an open stub 161 and a transmission line 162. The open stub 161 functions mainly as a parallel connection capacitance, while the transmission line 162 mainly as a series connection inductance. The matching circuit 16 can be expressed as an equivalent circuit shown in Fig. 2 accordingly. Then, the matching circuit 16 changes the impedance to obtain an output matched in impedance with the external circuit. The open stub is left free at its one end as an open end. Also, the distributed constant line is a line in which the inductance, the capacitance and the resistance are given in a distributed constant manner.

The conventional arrangement, however, had such a defect that since the output electrode 14 was connected through the wire to the matching circuit formed on the printed circuit board for example of the glass epoxy, influence of stray capacitance or inductive inductance of the wire caused variations in properties, which required an additional circuit for compensating for the variations.

### SUMMARY OF THE INVENTION

It is an object of the present invention to solve the above problem and then to resolve variations in properties due to the connection with such an external matching circuit.

Then, the present invention provides a surface acoustic wave apparatus comprising:
a surface acoustic wave element comprising:
a piezoelectric substrate;
two generation electrodes provided on said piezoelectric substrate, for generating a first surface acoustic wave and a second surface acoustic wave, respectively;
a surface acoustic wave waveguide provided on said piezoelectric substrate, for propagating said first and second surface acoustic waves in mutually opposite directions; and
an output electrode provided on said piezoelectric substrate, for extracting a convolution signal of the first and second surface acoustic waves; and
a matching circuit for effecting matching between said output electrode and an external circuit,
wherein at least a part of said matching circuit is formed on said piezoelectric substrate.

Also, the present invention provides a surface acoustic wave apparatus comprising:
a surface acoustic wave element comprising:
a piezoelectric substrate;
two generation electrodes provided on said piezoelectric substrate, for generation a first surface acoustic wave and a second surface acoustic wave, respectively;
a surface acoustic wave waveguide provided on said piezoelectric substrate, for propagating said first and second surface acoustic waves in mutually opposite directions; and
an output electrode provided on said piezoelectric substrate, for extracting a convolution signal of the first and second surface acoustic waves from a plurality of portions;
a circuit for summing a plurality of signals taken out from said plurality of portions, at least a part of said summing circuit being formed on said piezoelectric substrate; and
a matching circuit for effecting matching between said signal synthesizing circuit and an external circuit, wherein at least a part of said matching circuit is formed on said piezoelectric substrate.

Further the present invention provides a communication system using the apparatus.

Thus, the present invention can suppress the variations in properties of apparatus, can enable to obtain excellent properties without any adjustment, can permit the apparatus to be made compact, and can permit the apparatus to be produced in a reduced number of steps easily.

Also, the communication system of the invention can achieve high-quality communication in a simpler arrangement.

### BRIEF DESCRIPTION OF THE DRAWINGS

Fig. 1 is a schematic plane view to show a conventional SAW apparatus;
Fig. 2 is a drawing to show an equivalent circuit to a matching circuit in the conventional SAW apparatus;
Fig. 3 is a schematic plan view to show a first embodiment of SAW apparatus according to the present invention;
Fig. 4 is a drawing to show a change in impedance of an output electrode effected by the matching circuit in the first embodiment;
Fig. 5 is a schematic plan view to show a second embodiment of SAW apparatus according to the present invention;
Fig. 6 is a drawing to show an equivalent circuit to a matching circuit in the second embodiment;
Fig. 7 is a drawing to show the structure of a communication system in a third embodiment;
Fig. 8 is a drawing to show the structure of a transmitter in a fourth embodiment; and
Fig. 9 is a drawing to show the structure of a receiver in the fourth embodiment.

### DESCRIPTION OF THE PREFERRED EMBODIMENTS

Specific embodiments of the present invention will be described with reference to the accompanying drawings.

### First Embodiment

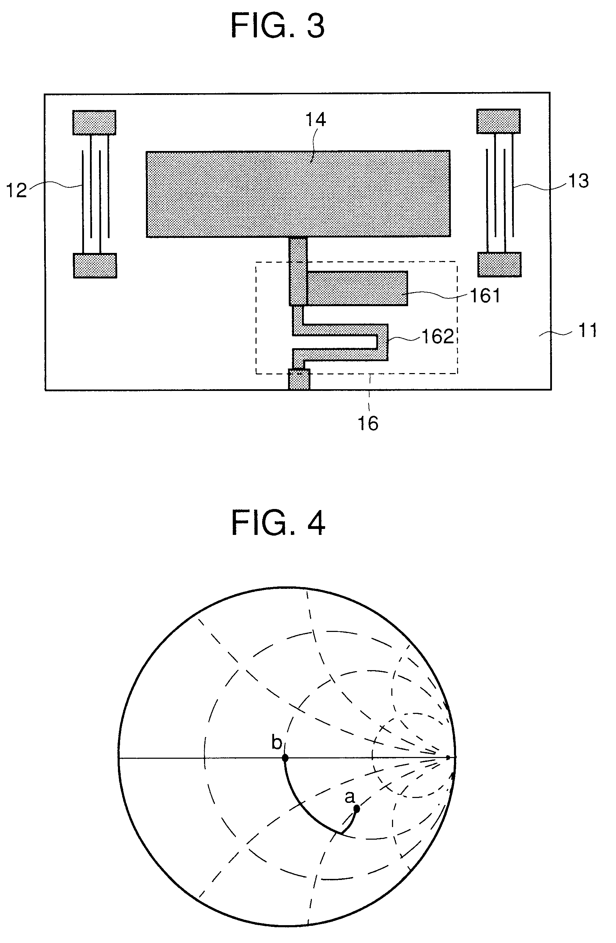

Fig. 3 is a schematic plan view to show the first embodiment of SAW apparatus according to the present invention. Fig. 4 is a Smith chart (impedance chart) to show a change in impedance effected by a matching circuit in the first embodiment.

In Fig. 3, reference numeral 11 designates a piezoelectric substrate. The piezoelectric substrate may be a piezoelectric substrate for example of lithium niobate. Numerals 12, 13 are electrodes for SAW generation formed as opposed at a proper distance to each other on the surface of substrate 11. The electrodes 12, 13 are interdigital electrodes, which are made of a conductor for example of aluminum, silver, gold, etc. Numeral 14 denotes an output electrode formed between the electrodes 12, 13. The output electrode 14 is made of a conductor for example of aluminum, silver, gold, etc. Numeral 16 is a matching circuit formed on the surface of substrate 11. The matching circuit 16 is composed of an open stub 161 and a transmission line 162, and is electrically connected directly to the output electrode 14 without a wire. The open stub 161 and the transmission line 162 are a distributed constant line made of a conductor for example of aluminum, silver, gold, etc.

In the SAW element of the present embodiment, an electric signal of center angular frequency ω is input into one generation electrode 12 to generate a first surface acoustic wave, which is let to enter the output electrode 14. Also, an electric signal of center angular frequency ω is input into the other generation electrode 13 similarly to generate a second surface acoustic wave, which is let to enter the output electrode 14 in the opposite direction to the first surface acoustic wave. Since the velocity of SAW on the output electrode 14 is smaller than that around the output electrode 14 by the mass load effect or the field short effect, the output electrode 14 functions as a SAW waveguide. The first and second surface acoustic waves propagate from the both ends of output electrode 14 therein in the mutually opposite directions then to generate an electric signal of center angular frequency 2ω by the parametric mixing phenomenon in the output electrode 14. The electric signal is integrated over the output electrode and taken out through the matching circuit 16, whereby a convolution electric signal of the two input signals matched with an external circuit can be obtained. Here, the open stub 161 functions mainly as a shunt capacitance and the transmission line 162 mainly as a series connection inductance. As a example, an open stub formed on a lithium niobate substrate in line width of 1 mm and in length of 10 mm becomes a parallel connection capacitance of about several 10 pF, and a transmission line in line width of 0.1 mm and in length of 20 mm becomes a series connection inductance of about several 10 nH. Then, the open stub 161 and the transmission line 162 provide a circuit equivalent to the equivalent circuit shown in Fig. 2, whereby an impedance of the output electrode is changed from point a to point b in Fig. 4 so as to be matched to the impedance of the external circuit.

Since the present embodiment is so arranged that the output electrode 14 is electrically connected directly to the matching circuit 16 without using a wire, the output electrode 14 can be connected to the external circuit without being influenced by the stray capacitance or the inductive inductance of wire.

In the present embodiment the matching circuit 16 is composed of the open stub 161 and the transmission line 162, but it can be constructed using another circuit element such as a short stub, a gap or parallel lines. The short stub is a stub connected to the ground electrode at one end.

### Second Embodiment

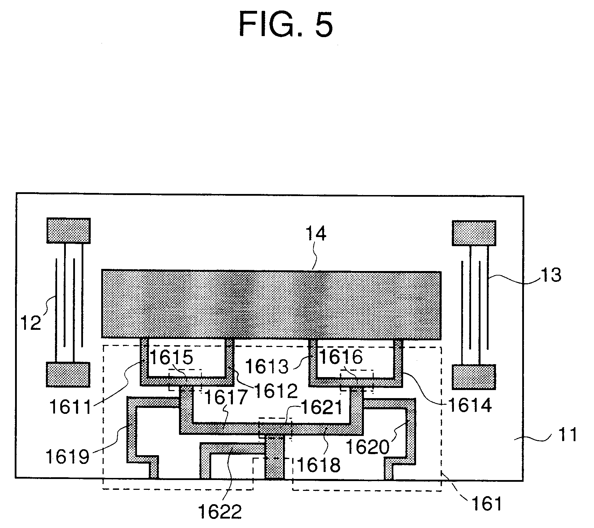

Fig. 5 is a schematic plan view to show a second embodiment of SAW apparatus according to the present invention. In Fig. 5, similar members to those in Fig. 1 and Fig. 3 are denoted by the same reference numerals.

The present embodiment is different from the first embodiment as described above in that a matching circuit 161 serves as an output summing circuit and as a matching circuit, signals are taken out of a plurality of portions in an output electrode 14 through distributed constant lines 1611, 1612, 1613, 1614 formed on a substrate 11, and the signals are summed by summing circuits 1615, 1616, transmission lines 1617, 1618, short stubs 1619, 1620, a summing circuit 1621 and a short stub 1622 similarly formed on the substrate 11 so as to match the impedance to that of the external circuit.

The signal processing performance of the SAW element composed of the two generation electrodes 12, 13 and the output electrode 14 on the substrate 11 can be expressed as a product (BT product) between a band width (B) and an interaction time (T). The interaction time is proportional to the length of output electrode 14. In order to enhance the signal processing performance, the length of output electrode 14 is normally set as long as possible, but a too long electrode would cause a great difference in distance between each position on the output electrode 14 and an output taking-out port, which makes unignorable a phase difference between electric signals propagating from positions on the output electrode 14 to the output taking-out port. In order to minimize the influence of the phase shift, the present embodiment is so arranged that signals are taken out by the distributed constant lines from a plurality of portions on the output electrode 14 to make as small a difference in distance from positions on the output electrode 14 to an output taking-out port as possible. It is preferred that output taking-out ports are arranged at equal intervals and a distance between two adjacent taking-out ports is sufficiently shorter than the wavelength of electromagnetic waves propagating on the output electrode 14.

In the present embodiment, an electric signal generated on the output electrode 14 goes mainly into a distributed constant line closest to the generated position among the distributed constant lines 1611, 1612, 1613, 1614 arranged substantially at equal intervals to the output electrode 14. Signals transmitted through the distributed constant line 1611 and through the distributed constant line 1612 are summed by a summing circuit 1615, and a resultant signal enters the transmission line 1617. The signal is changed in impedance by the transmission line 1617 and the short stub 1619 then to enter the summing circuit 1621. Similarly, signals transmitted through the distributed constant line 1613 and through the distributed constant line 1614 are summed by the summing circuit 1616, and a resultant signals enters the transmission line 1618. The signal is changed in impedance by the transmission line 1618 and the short stub 1620 then to enter the summing circuit 1621. An output from the summing circuit 1621 is further changed in impedance by the short stub 1622 to be output with an impedance matched to that of the external circuit.

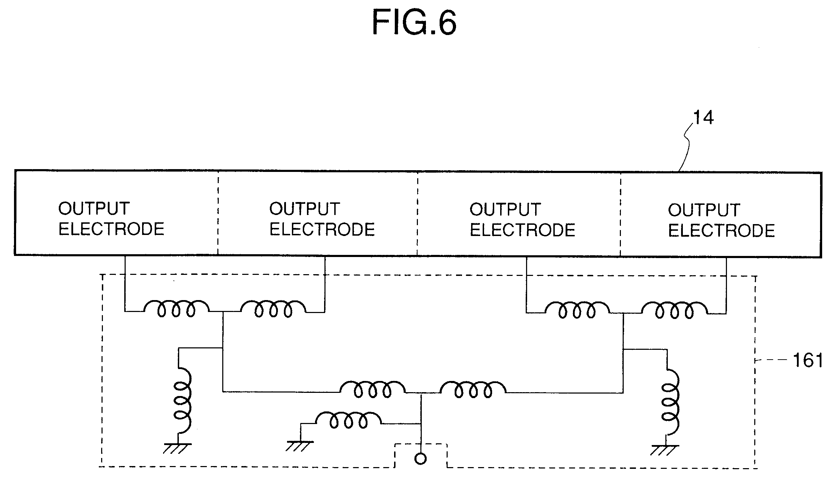

The distributed constant lines 1611, 1612, 1613, 1614 and the transmission lines 1617, 1618 each function mainly as a series connection inductance and the short stubs 1619, 1620, 1622 each mainly as a shunt inductance. Accordingly, the matching circuit 161 shown in Fig. 5 is equivalent to the circuit as shown in Fig. 6. Arranging the distributed constant lines 1611, 1612, 1613, 1614 at equal intervals, it may be assumed that equally-divided (quarterly divided in the present embodiment) regions of the output electrode are connected to the respective distributed constant lines and it appears that elements with same impedance are connected to the lines. Therefore, the impedance matching can be effected by setting same line width and length for distributed constant lines 1611, 1612, 1613, 1614, same line width and length for transmission lines 1617, 1618, and same line width and length for short stubs 1619, 1620 so that the elements with same impedance are connected to the respective divided regions of output electrode 14 to sum signals.

The present embodiment also has the same operational effects as the first embodiment as described above, which can prevent degradation of properties due to inductance or stray capacitance of wires and the electromagnetic induction between wires as seen in cases where signals are taken out through wires from a plurality of portions in output electrode 14. Further, the present embodiment is so arranged that signals are taken out from a plurality of portions in the output electrode 14 and that the distributed constant lines and the transmission lines in same length are connected thereto, whereby the electric signals generated in the portions in the output electrode 14 can be summed while preventing a reduction in efficiency due to a phase difference.

In the present embodiment a plurality of distributed constant lines are connected to the output electrode 14, but the output electrode may be arranged to be divided into a plurality of portions for example with each output electrode segment being connected to a distributed constant line in another arrangement.

Also, the matching circuit is composed of the short stubs 1619, 1620, 1622 and the transmission lines 1617, 1618 in the present embodiment, but may be composed of other circuit elements such as open stubs, gaps, or parallel lines.

Also, the number of taking-out portions from the output electrode 14 is not limited to four. With a different number, it is preferred that distances between taking-out ports of output electrode 14 and a signal summing point are substantially equal to each other to avoid a large phase shift between signals taken out of the taking-out ports.

In the second embodiment as described above, the arrangement can be modified such that at least the summing circuits are formed on the substrate 11 but a part of the matching circuit is formed on another substrate other than the substrate 11, whereby the number of wires can be greatly reduced while stopping the degradation of properties due to wires.

In the first and second embodiments, an open stub, a short stub, or a transmission line is a type of distributed constant line.

Also, if the first or second embodiment is so arranged that the SAW generation electrodes 12, 13 are constructed as double electrodes (split electrodes), reflection of SAW can be suppressed in the SAW generation electrodes 12, 13 so as to further enhance the properties of element.

It should be further noted in the first and second embodiments that the substrate 11 is not limited to the piezoelectric crystal of lithium niobate, but may be any material or structure with the parametric mixing effect, for example a semiconductor or a structure with a piezoelectric film being provided on a glass substrate.

Also, although the first and second embodiments are so arranged that surface acoustic waves generated by the SAW generation electrodes are directly guided into the SAW waveguide, a beam width compressor such as a horn waveguide or a multi strip coupler may be provided between the generation electrodes and the SAW waveguide. Also, the SAW generation electrodes may be constructed with a shape for concentrating surface acoustic waves, for example in an arc shape.

Further, the first and second embodiments employ the distributed constant lines for the matching circuit. In that case, it is preferred that the distributed constant lines are formed thicker than the SAW generation electrodes in order to make the resistance smaller.

There are various distributed constant lines, for example a micro strip line, a strip line, a suspended line, a coplanar line, a slot line, etc. In the present invention either of the lines can be applicable, and the first and second embodiments employed the micro strip lines. A micro strip line is arranged such that a ground electrode is provided on the bottom of substrate and a signal line on the surface of substrate, and therefore an occupying area of the matching circuit can be made small.

Also, in case of the coplanar line being employed, a ground electrode or electrodes are provided on one side or on the both sides of signal line, which can obviate the ground electrode on the bottom side of substrate, and a material for stem or package for mounting the substrate can be selected arbitrarily.

### Third Embodiment

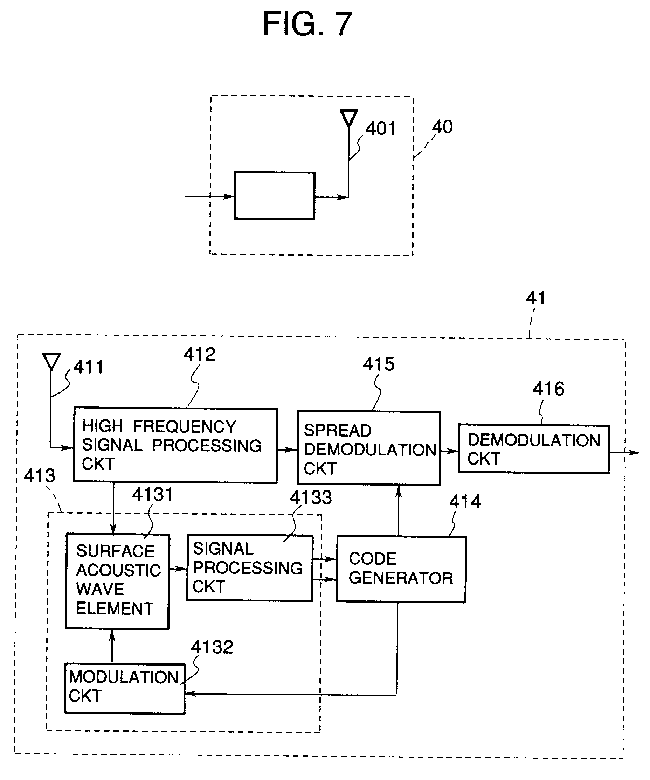

Fig. 7 is a block diagram to show an example of communication system using the SAW device as described above. In Fig. 7, reference numeral 40 designates a transmitter. The transmitter spread-spectrum-modulates a signal to be transmitted using spread codes and transmits the modulated signal through an antenna 401. The transmitted signal is received by a receiver 41 and demodulated thereby. The receiver 41 is composed of an antenna 411, a high frequency signal processing unit 412, a synchronous circuit 413, a code generator 414, a spread demodulation circuit 415, and a demodulation circuit 416. A signal received through the antenna 411 is properly filtered and amplified in the high frequency signal processing unit 412 to be output as a signal in the transmission frequency band or as a converted a signal in a proper intermediate frequency band. The output signal is input into the synchronous circuit 413. The synchronous circuit 413 is composed of a SAW device 4131 as described in the preceding embodiments of the present invention, a modulation circuit 4132 for modulating a reference spread code supplied from the code generator 414, and a signal processing circuit 4133 for processing the signal output from the SAW device 4131 and outputting a spread code synchronizing signal and a clock synchronizing signal for the transmitted signal to the code generator 414. Input into the SAW device 4131 are an output signal from the high frequency signal processing unit 412 and an output signal from the modulation circuit 4132, to execute the convolution operation of the two input signals. Supposing the reference spread code supplied from the code generator 414 to the modulation circuit 4132 is a time-inverted code of the spread code transmitted from the transmitter, a correlation peak is output from the SAW device 4131 when a synchronization-only spread code component included in the received signal and the reference spread code coincide with each other on the waveguide of SAW device 4131. The signal processing circuit 4133 detects the correlation peak from the signal received from the SAW device 4131, obtains an amount of deviation of code synchronization from a time of from the code start of the reference spread code to the output of correlation peak, and outputs the code synchronizing signal and the clock signal to the code generator 414. After synchronization is established, the code generator 414 generates spread codes coincident in clock and spread code phase with the transmission-side spread codes. The spread codes are input into the Spread demodulation circuit 415, which restores the signal before the spread modulation. Since the signal output from the spread demodulation circuit 415 is a signal modulated by a popularly used modulation method such as the so-called frequency modulation or phase modulation, it can be demodulated by the demodulation circuit 416, which is one well known by those who skilled in the art.

### Fourth Embodiment

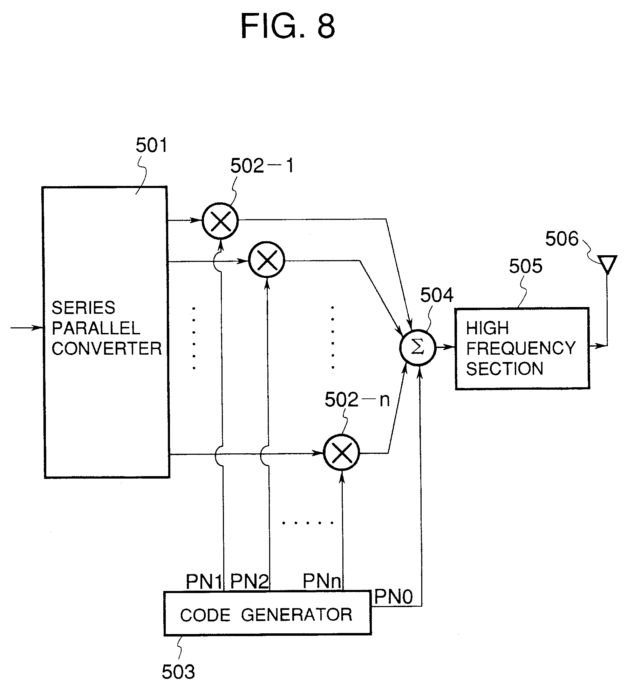

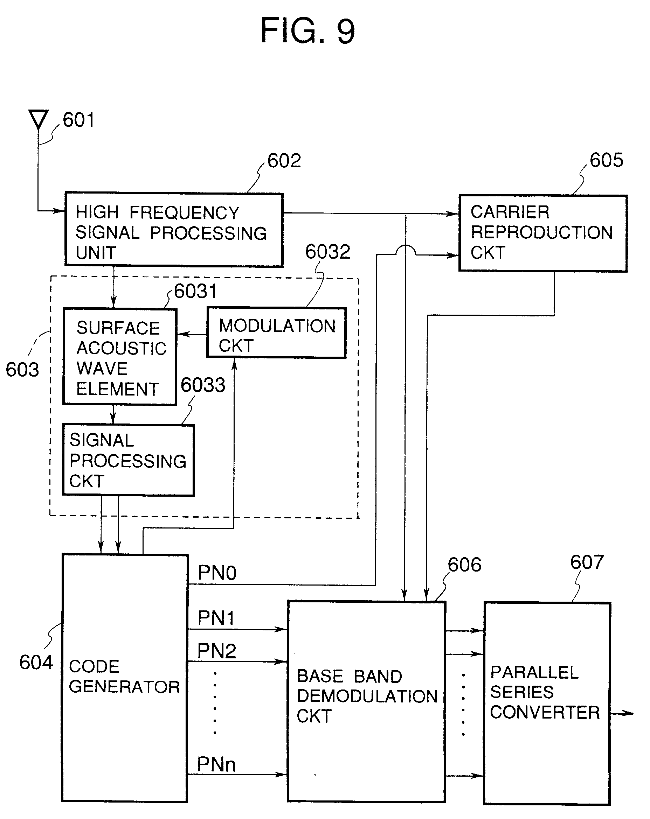

Fig. 8 and Fig. 9 are block diagrams to show an example of a transmitter and a receiver in a communication system employing the SAW device as described above. The present embodiment employs the CDM (Code division multiplexing) method as the communication method. In Fig. 8, numeral 501 denotes a serial-parallel converter for converting serial input data into n pieces of parallel data, 502-1 to 502-n multipliers for multiplying the parallel data pieces by n spread codes output from the spread code generator, 503 a spread code generator for generating n mutually different spread codes and a synchronization-only spread code, 504 an adder for summing up the synchronization-only spread code output from the spread code generator 503 and n outputs from the multipliers 502-1 to 502-n, 505 a high frequency section for converting an output from the adder 504 into a transmission frequency signal, and 506 a transmission antenna. Further, in Fig. 9, numeral 601 is a receiving antenna, 602 a high frequency signal processing unit, 603 a synchronous circuit for capturing and maintaining synchronization to transmission-side spread codes and clocks, 604 a spread code generator for generating n+1 spread codes and reference spread code same as the transmission-side spread codes, based on the code synchronizing signal and clock signal supplied from the synchronous circuit 603, 605 a carrier reproduction circuit for reproducing a carrier signal from a carrier reproduction spread code output from the spread code generator 604 and an output from the high frequency signal processing unit 602, 606 a base band demodulation circuit for demodulating the signal in the base band, using an output from the carrier reproduction circuit 605, an output from the high frequency signal processing unit 602, and n spread codes of outputs from the spread code generator 604, and 607 a parallel-serial converter for parallel-to-serial-converting the n parallel demodulated data of outputs from the base band demodulation circuit 606 into serial data.

In the above arrangement, input data is first converted by the serial-parallel converter 501 into parallel data of n pieces equal to the code division multiplexing number in the transmitter. On the other hand, the spread code generator 503 generates n+1 mutually different spread codes PN0 to PNn at a same code cycle. Among them, PN0 is only for synchronization and carrier reproduction, which is supplied directly to the adder 504 without being modulated by the parallel data. The n rest spread codes are modulated by the n parallel data in the multipliers 502-1 to 502-n, and the modulated data is input into the adder 504. The adder 504 linearly sums up the n+1 signals input thereinto and outputs the sum as a base band signal to the high frequency section 505. The high frequency section 505 then converts the base band signal into a high frequency signal with a proper center frequency and transmits it through the transmission antenna 506. In the receiver, the signal received through the receiving antenna 601 is properly filtered and amplified in the high frequency signal processing unit 602 to be output as a signal in the transmission frequency band or as a converted signal in a suitable intermediate frequency band. The signal is input into the synchronous circuit 603. The synchronous circuit 603 is composed of a SAW device 6031 as described in the previous embodiments of the present invention, a modulation circuit 6032 for modulating the reference spread code supplied from the code generator 604, and a signal processing circuit 6033 for processing a signal output from the SAW device 6031 and outputting a spread code synchronizing signal and a clock synchronizing signal for transmitted signal to the spread code generator 604. An output signal from the high frequency signal processing unit 602 and an output signal from the modulation circuit 6032 are input into the SAW device 6031, which executes a convolution operation of the two input signals. Supposing the reference spread code supplied from the code generator 604 to the modulation circuit 6032 is a time-inverted code of the synchronization-only spread code transmitted from the transmitter, a correlation peak is output from the SAW device 6031 when the synchronization-only spread code component included in the received signal and the reference spread code coincide with each other on the waveguide in the SAW device 6031. The signal processing circuit 6033 detects the correlation peak from the signal supplied from the SAW device 6031, obtains an amount of deviation of code synchronisation from the time between the code start of the reference spread code and the correlation peak output, and outputs a code synchronizing signal and a clock signal to the spread code generator 604. After synchronization is established, the spread code generator 604 generates spread codes coincident in clock and spread code phase with the transmission-side spread codes. Among these codes, the synchronization-only spread code PN0 is supplied to a carrier reproduction circuit 605. The carrier reproduction circuit 605 inversely spreads the received signal, which is an output from the high frequency signal processing unit 602, in the transmission frequency band or in the intermediate frequency band if converted, with the synchronization-only spread code PN0, to reproduce the carrier waves in the transmission frequency band or in the intermediate frequency band. The carrier reproduction circuit 605 may be arranged as a circuit utilizing the phase-lock loop, for example. A multiplier multiplies the received signal by the synchronization-only spread code PN0. After synchronization is achieved, the synchronization-only spread code in the received signal is coincident in clock and code phase with the reference synchronization-only spread code. Since the transmission-side synchronization-only spread code was not modulated by data, it is inversely spread by the multiplier and a carrier component appears in an output from the multiplier. The output is then input into a band-pass filter to extract only the carrier component. The carrier component is output from the filter. The output is next input into a well-known phase-lock loop composed of a phase detector, a loop filer and a voltage control oscillator. The voltage control oscillator outputs as a reproduced carrier a signal phase-locked with the carrier component output from the band-pass filter. The reproduced carrier is supplied to the base band demodulation circuit 606. The base band demodulation circuit produces a base band signal from the reproduced carrier and the output from the high frequency signal processing unit 602. The base band signal is distributed to n channels and inversely spread by the spread codes PN1 to PNn of outputs from the spread code generator 604 every code division channel. Subsequently, data is demodulated. The parallel demodulated data of n pieces is converted into serial data by the parallel-serial convertor 607, and the serial data is then output.

Using the CDM method as communication method, a plurality of data can be transmitted in bundle, which can increase a transmission capacity.

Also, the present embodiment showed an example of bi-level modulation, but may employ the orthogonal modulation or other modulation methods.

Also, the communication system using the SAW device of the present invention as in the third and fourth embodiments can perform high-quality transmission in a simpler arrangement.

As described above, at least a part of the matching circuit is provided on the same substrate as the SAW element in the present invention, which can prevent the variations in properties, which can realize excellent properties without need of circuit adjustment, and which can decrease the number of components.

In addition, the matching circuit can be formed at the same time as the SAW element, which can reduce the number of production steps. Further, the matching circuit can be produced in a compact size and easily using the distributed constant lines.

A surface acoustic wave apparatus includes a surface acoustic wave (SAW) element and a matching circuit. The SAW element includes a piezoelectric substrate, two generation electrodes provided on the piezoelectric substrate, for generating a first surface acoustic wave and a second surface acoustic wave, respectively, and an output electrode provided on the piezoelectric substrate, for propagating the first and second surface acoustic waves in mutually opposite directions to extract a convolution signal of the first and second surface acoustic waves. The matching circuit effects impedance matching between the element and an external circuit. In the apparatus at least a part of the matching circuit is formed on the piezoelectric substrate.

## Claims

1. A surface acoustic wave apparatus comprising:
a surface acoustic wave element comprising:
a piezoelectric substrate;
two generation electrodes provided on said piezoelectric substrate, for generating a first surface acoustic wave and a second surface acoustic wave, respectively;
a surface acoustic wave waveguide provided on said piezoelectric substrate, for propagating said first and second surface acoustic waves in mutually opposite directions; and
an output electrode provided on said piezoelectric substrate, for extracting a convolution signal of the first and second surface acoustic waves; and
a matching circuit for effecting matching between said output electrode and an external circuit, wherein at least a part of said matching circuit is formed on said piezoelectric substrate.

2. A surface acoustic wave apparatus according to Claim 1, wherein said output electrode serves also as the surface acoustic wave waveguide.

3. A surface acoustic wave apparatus according to Claim 1, wherein said matching circuit is connected to the output electrode by a line formed on the substrate.

4. A surface acoustic wave apparatus according to Claim 1, wherein said matching circuit is formed of a distributed constant line.

5. A surface acoustic wave apparatus according to Claim 4, wherein said distributed constant line is a micro strip line.

6. A surface acoustic wave apparatus according to Claim 4, wherein said distributed constant line is a coplanar line.

7. A surface acoustic wave apparatus comprising:
a surface acoustic wave element comprising:
a piezoelectric substrate;
two generation electrodes provided on said piezoelectric substrate, for generating a first surface acoustic wave and a second surface acoustic wave, respectively;
a surface acoustic wave waveguide provided on said piezoelectric substrate, for propagating said first and second surface acoustic waves in mutually opposite directions; and
an output electrode provided on said piezoelectric substrate, for extracting a convolution signal of the first and second surface acoustic waves from a plurality of portions;
a circuit for synthesizing a plurality of signals taken out from said plurality of portions, at least a part of said synthesizing circuit being formed on said piezoelectric substrate; and
a matching circuit for effecting matching between said signal synthesizing circuit and an external circuit, wherein at least a part of said matching circuit is formed on said piezoelectric substrate.

8. A surface acoustic wave apparatus according to Claim 7, wherein said output electrode serves also as the surface acoustic wave waveguide.

9. A communication system comprising:
a transmitter for transmitting a signal modulated according to information; and
a receiver comprising:
a code generator for generating a reference signal; a surface acoustic wave apparatus for outputting a convolution signal of a received signal and the reference signal; and
a circuit for demodulating the information using the convolution signal output from said surface acoustic wave apparatus;
said surface acoustic wave apparatus comprising:
a surface acoustic wave element comprising:
a piezoelectric substrate;
two generation electrodes provided on said piezoelectric substrate, for generating a first surface acoustic wave and a second surface acoustic wave, respectively;
a surface acoustic wave waveguide provided on said piezoelectric substrate, for propagating said first and second surface acoustic waves in mutually opposite directions; and
an output electrode provided on said piezoelectric substrate, for extracting a convolution signal of the first and second surface acoustic waves; and
a matching circuit for effecting matching between said output electrode and an external circuit, wherein at least a part of said matching circuit is formed on said piezoelectric substrate.

10. A communication system comprising:
a transmitter for transmitting a signal modulated according to information; and
a receiver comprising:
a code generator for generating a reference signal;
a surface acoustic wave apparatus for outputting a convolution signal of a received signal and the reference signal; and
a circuit for demodulating the information using the convolution signal output from said surface acoustic wave apparatus;
said surface acoustic wave apparatus comprising:
a surface acoustic wave element comprising:
a piezoelectric substrate;
two generation electrodes provided on said piezoelectric substrate, for generating a first surface acoustic wave and a second surface acoustic wave, respectively;
a surface acoustic wave waveguide provided on said piezoelectric substrate, for propagating said first and second surface acoustic waves in mutually opposite directions; and
an output electrode provided on said piezoelectric substrate, for extracting a convolution signal of the first and second surface acoustic waves from a plurality of portions;
a circuit for synthesizing a plurality of signals taken out from said plurality of portions, at least a part of said synthesizing circuit being formed on said piezoelectric substrate; and
a matching circuit for effecting matching between said signal synthesizing circuit and an external circuit, wherein at least a part of said matching circuit is formed on said piezoelectric substrate.
